Europäisches Patentamt

**European Patent Office**

**Office européen des brevets**

(11) Numéro de publication: **0 109 321**
**A1**

(12) **DEMANDE DE BREVET EUROPEEN**

(21) Numéro de dépôt: **83402076.0**

(22) Date de dépôt: **25.10.83**

(51) Int. Cl.³: **H 01 L 21/268**, H 01 L 21/263, H 01 L 21/285

(30) Priorité: **04.11.82 FR 8218499**

(71) Demandeur: **THOMSON-CSF, 173, Boulevard Haussmann, F-75379 Paris Cedex 08 (FR)**

(72) Inventeur: **Pribat, Didier, THOMSON-CSF SCPI 173, bld Haussmann, F-75379 Paris Cedex 08 (FR)**
Inventeur: **Delage, Sylvain, THOMSON-CSF SCPI 173, bld Haussmann, F-75379 Paris Cedex 08 (FR)**
Inventeur: **Dieumegard, Dominique, THOMSON-CSF SCPI 173, bld Haussmann, F-75379 Paris Cedex 08 (FR)**
Inventeur: **Poirier, Raymond, THOMSON-CSF SCPI 173, bld Haussmann, F-75379 Paris Cedex 08 (FR)**

(43) Date de publication de la demande: **23.05.84**
**Bulletin 84/21**

(74) Mandataire: **Wang, Pierre et al, THOMSON-CSF SCPI 173, Bld Haussmann, F-75379 Paris Cedex 08 (FR)**

(84) Etats contractants désignés: **DE GB IT NL**

(54) **Procédé de passivation de la surface d'un matériau semiconducteur et son application à la fabrication de dispositifs à semi-conducteur.**

(57) L'invention se rapporte à un procédé d'abaissement du potentiel de surface d'un matériau semiconducteur.

L'invention a pour objet un traitement des surfaces semiconductrices (4) par un faisceau pulsé d'impulsions laser.

L'invention s'applique notamment à la réalisation de diode Schottky, à l'amélioration des contacts métal-semiconducteur et à la passivation de surfaces de matériaux semiconducteurs.

PROCEDE DE PASSIVATION DE LA SURFACE D'UN MATERIAU
SEMICONDUCTEUR ET SON APPLICATION A LA FABRICATION
DE DISPOSITIFS A SEMICONDUCTEUR

La présente invention concerne un procédé de modification de la barrière de potentiel présente à la surface d'un matériau semiconducteur et son application à la passivation des surfaces de tels matériaux.

Il est bien connu que la rupture de périodicité d'un matériau cristallin semiconducteur peut donner naissance à des états électroniques intrinsèques situés dans la bande d'énergie interdite. En particulier, l'interface matériau semiconducteur-vide constitue un bon exemple d'une telle rupture de périodicité. La surface libre d'un semiconducteur présente du point de vue électronique des propriétés bien spécifiques. Ces états de surface sont essentiellement dus, à la différence d'un métal, au petit nombre de porteurs de charges dans le semiconducteur. D'autre part, les défauts structuraux de la surface du semiconducteur sont susceptibles d'introduire des états (dits extrinsèques) dans la bande d'énergie interdite. Ces défauts peuvent être par exemple des lacunes superficielles d'atomes ou au contraire des atomes supplémentaires. Les diverses absorptions d'atomes étrangers sont aussi susceptibles de créer de tels états. Les densités d'états induites à la surface des cristaux semiconducteurs par la conjugaison de ces phénomènes peuvent être considérables et réaliser un bloquage du niveau de Fermi. Il s'ensuit que la hauteur de la barrière de potentiel d'un contact redresseur métal-semiconducteur ne dépend ni du travail de sortie d'une charge du métal considéré, ni de l'affinité électronique entre le métal et le semiconducteur, mais uniquement de la position de bloquage du niveau de Fermi du semiconducteur.

La présence, dans un contact métal-semiconducteur, d'une barrière de potentiel élevée entraîne la difficulté d'établir de bons contacts ohmiques.

La barrière de surface naturelle qui existe sur un semiconducteur entraîne souvent pour la réalisation de circuits intégrés à transistors à effet de champ (MESFET sur arséniure de gallium par exemple) une opération technologique supplémentaire rendue nécessaire afin de réduire l'influence de la hauteur de barrière entre et sous les contacts (source-drain).

Afin de pallier ces inconvénients, l'invention propose de traiter les surfaces de matériau semiconducteur par irradiations à l'aide d'un faisceau d'énergie, l'énergie pouvant être apportée par des particules telles que les photons, les électrons ou les ions, afin de modifier la barrière de potentiel de surface de ce matériau. En particulier, l'invention contribuera à abaisser la barrière de potentiel d'un semiconducteur de type n. D'une manière préférentielle, on choisira un faisceau pulsé.

L'invention a donc pour objet un procédé de passivation d'au moins une région superficielle d'un matériau semiconducteur sur une épaisseur déterminée, caractérisé en ce qu'il comporte une étape consistant à irradier ladite région à l'aide d'un faisceau énergétique, la quantité d'énergie apportée à ladite région étant suffisante pour dépassser le point de fusion dudit matériau par échauffement et étant inférieure à son point de destruction, de manière à modifier le potentiel de surface de ladite région.

L'invention a également pour objet un procédé de fabrication d'un dispositif à semiconducteur comportant une telle étape de passivation.

L'invention sera mieux comprise et d'autres caractéristiques et avantages apparaîtront au moyen de la description qui va suivre et par référence aux figures qui l'accompagnent, parmi lesquelles :

- la figure 1 représente les diagrammes d'énergie d'un métal et d'un semiconducteur de type n avant contact,

- la figure 2 représente le diagramme d'énergie d'un contact métal-semiconducteur,

- la figure 3 est un diagramme courant-tension,

- les figures 4 et 5 sont des diagrammes capacité-tension,

- la figure 6 est une vue partielle en coupe d'un transistor à effet de champ.

Dans le cas d'un contact métal-semiconducteur, le potentiel induit par la différence entre les niveaux de Fermi du métal et du semiconducteur est masqué par les charges de surface du semiconducteur et se répartit le long d'une couche interfaciale d'épaisseur plus ou moins importante qui est franchie par effet tunnel lorsque le contact redresseur est polarisé en direct. Les charges d'interface sont de plus supposées rester en équilibre avec le métal de façon qu'elles n'affectent pas la relation quadratique qui existe entre l'inverse de la capacité et la tension de polarisation inverse du contact redresseur.

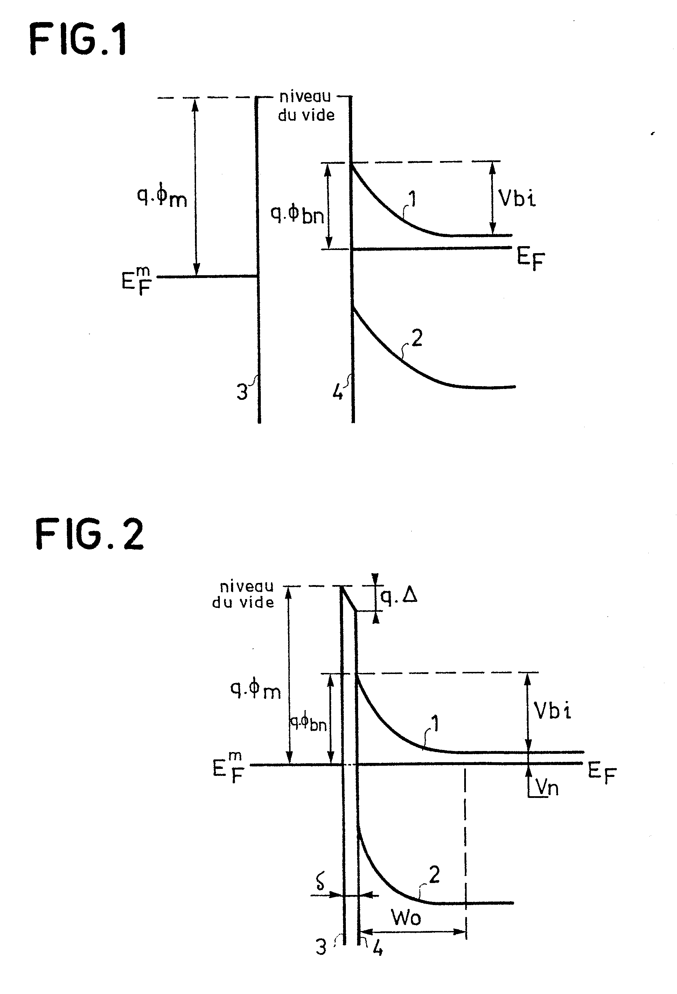

La figure 1 représente les diagrammes d'énergie d'un métal et d'un semiconducteur de type n avant contact. La partie gauche de la figure se rapporte au matériau métallique, limité par sa surface 3, du futur contact et la partie droite au matériau semiconducteur limité par sa surface 4. Ce sont des diagrammes d'énergie classiques pour un métal et un semiconducteur de type n près d'une surface libre. Pour la partie gauche de la figure, $E_F^m$ représente le niveau de Fermi du métal, $q.\Phi_m$ le travail de sortie d'un électron (q étant la charge de l'électron et $\Phi_m$ le potentiel séparant le niveau de Fermi $E_F^m$ du niveau du vide). Pour la partie droite de la figure, $E_F$ représente le niveau de Fermi du semiconducteur, la courbe 1 est la limite inférieure de la bande de conduction, la courbe 2 est la limite supérieure de la bande de valence, Vbi est le potentiel de surface du semiconducteur considéré, et $\Phi$ bn sa hauteur de barrière.

La figure 2 représente le diagramme d'énergie d'un contact réalisé à partir d'un métal et d'un semiconducteur définis précédemment. Le contact provoque l'alignement des niveaux de Fermi $E_F^m$ et $E_F$. $\Delta$ représente le potentiel d'interface. La zone délimitée par les surfaces 3 et 4 d'épaisseur $\delta$, représente l'épaisseur de la couche d'interface. Wo est la largeur de la région de charge d'espace.

La situation décrite ci-dessus, et représentée par les figures 1 et 2, s'applique en particulier aux surfaces d'arséniure de gallium Ga As référencées (100) en cristallographie et plus généralement aux surfaces (100) et (110) des matériaux semiconducteurs formés de composés dont les éléments sont situés dans les groupes III et V du tableau périodique des éléments. Le potentiel d'une surface (100) de Ga As, mesuré par photoémission et sonde de KELVIN, varie fortement autour de 750 mV pour une surface non passivée par un traitement physico-chimique approprié. Les hauteurs de barrières de potentiel associées à des contacts métal-semiconducteur peuvent être mesurées par des méthodes courant-tension I(V) ou capacité-tension C(V).

Pour une diode réalisée par un contact métal-semiconducteur (diode Schottky), la relation qui donne le courant I qui traverse la diode en fonction de la tension appliquée en direct à cette diode est :

4

$$I = Is \left[ \exp \left( \frac{qV}{nkT} \right) - 1 \right]$$

où n est un facteur d'idéalisation proche de l'unité. Is est le courant de saturation inverse et est relié à $\Phi_{bn}$ par la relation :

$$Is = A^* T^2 \exp \left( - \frac{q \Phi_{bn}}{k T} \right)$$

où $A^*$ est la constante de RICHARDSON modifiée. De la formule précédente, on obtient :

$$\Phi_{bn} = \frac{k T}{q} . \ln \left( \frac{A^* T^2}{Is} \right)$$

On obtient donc $\Phi_{bn}$ à partir de la caractéristique courant-tension d'une diode.

La largeur Wo de la région de charge d'espace est reliée à la tension de polarisation V appliquée en inverse sur la diode par la relation :

$$W = \left[ \frac{2 \varepsilon_S}{q Nd} \left( Vbi - V - \frac{kT}{q} \right) \right]^{\frac{1}{2}}$$

où Vbi est le potentiel de surface, q la charge de l'électron, Nd la densité d'impuretés ionisées et $\varepsilon_S$ la constante diélectrique du matériau semiconducteur dans la région de charge d'espace. La diode polarisée en inverse présente, à l'instar d'un condensateur d'épaisseur Wo et de constante diélectrique $\varepsilon_S$, une capacité C. La capacité C par unité de surface est :

$$C = \frac{\varepsilon_S}{Wo} = \left[ \frac{q \varepsilon_S Nd}{2 \left( Vbi - V - \frac{kT}{q} \right)} \right]^{\frac{1}{2}}$$

On remarque que C décroît quand V augmente. Cette relation peut encore s'écrire :

$$C^{-2} = \frac{2 \left( Vbi - V - \frac{k T}{q} \right)}{q \varepsilon_S Nd}$$

Si Nd est une constante dans la zone de charge d'espace, la courbe donnant $C^{-2}$ en fonction de V est une droite. A partir de cette courbe, on peut déterminer Vbi puis la hauteur de la barrière de potentiel $\Phi_{bn} = Vbi + \dfrac{kT}{q} + Vn$ où Vn est la profondeur du niveau de Fermi en-dessous de la bande de conduction. Dans le cas de contacts aluminium-arséniure de gallium (Al/Ga As) ou mercure-arséniure ee gallium (Hg/Ga As) la barrière est de l'ordre de 850 mV et donc peu différente du potentiel de surface. Dans le cas de contacts or-arséniure de gallium Au/Ga As, les hauteurs de barrière sont relativement élevées, environ 950 mV. Ces valeurs éievées s'expliquent par une rapide diffusion de l'or dans l'arséniure de gaílium qui crée des niveaux accepteurs dans la bande interdite, près de la bande de valence. Le niveau de Fermi se trouve alors bloqué plus bas dans la bande interdite par des niveaux de volume ce qui donne naissance à une barrière plus éievée.

Quelques exemples de courbes I(V) et C(V) sont données ci-après pour des contacts Au/Ga As (100) où la partie Ga As est dopée à $3.10^{16}$ atomes/cm$^3$. Dans tous les cas, il est important de bien noter que le potentiel de surface Vbi est de très près associé à la hauteur de barrière $\Phi_{bn}$ obtenue après le contact métal-semiconducteur.

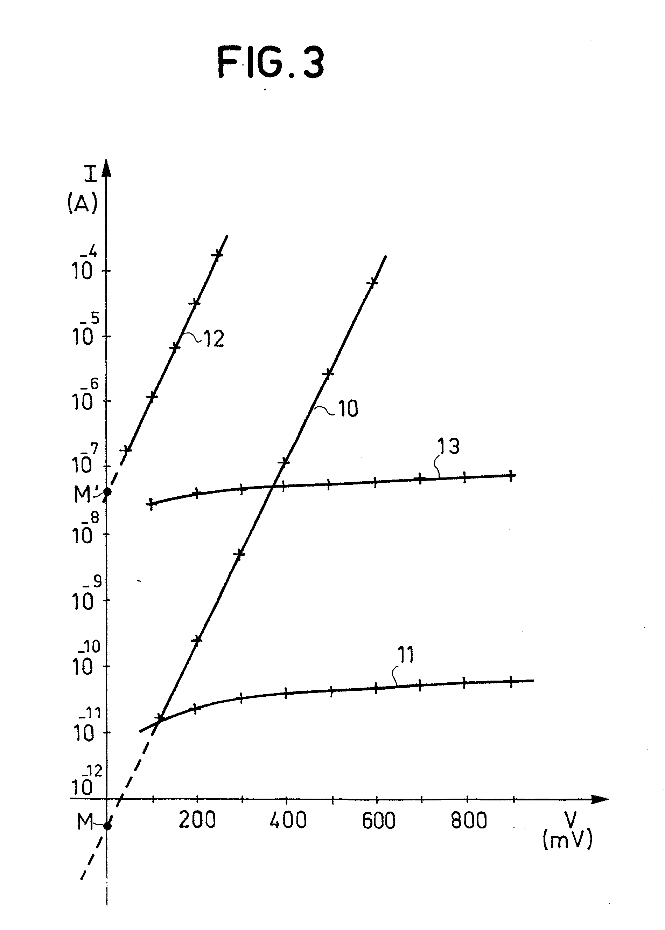

La figure 3 est un diagramme courant-tension I(V) pour la diode définie dans le paragraphe précédent. L'axe des courants est gradué en ampères et l'axe des tensions en millivolts. Les courbes 10 et 11 sont relatives à une diode qui n'a pas subi le traitement selon l'invention. La courbe 10 a été tracée en polarisation directe et la courbe 11 en polarisation inverse. L'intersection de la courbe 10 avec l'axe des ordonnées (point M) donne la valeur de Is.

La figure 3 donne également l'allure des courbes I(V) en direct (courbe 12) et en inverse (courbe 13) pour une diode ayant subi un traitement suivant l'invention. Ce traitement consiste dans un mode préférentiel, à réaliser des apports d'énergie par irradiation à l'aide d'un faisceau pulsé délivré par un laser, sur des surfaces semiconductrices. Ces irradiations sont effectuées dans un domaine d'énergie tel qu'elles n'entraînent pas de dégradation fonda-mentaie du matériau. La longueur d'onde des impulsions du faisceau laser peut se situer dans le visible ou le proche infra-rouge. La durée des impulsions est par exemple de l'ordre de 25 nanosecondes. Ceci permet des dépôts d'énergie considérables sur des épaisseurs très faibles. On peut ainsi recristalliser des couches semiconductrices qui ont été implantées d'impuretés dopantes. Le couplage énergétique entre les photons incidents et le réseau cristallin du semiconducteur irradié s'effectue par l'intermédiaire du système électronique du semiconducteur. L'énergie absorbée par le système électronique est ensuite cédée au réseau par émission de phonons. On admet que pour des durées d'impulsions énergétiques inférieures à 500 nanosecondes, la recristallisation s'effectue à partir d'une phase liquide. Des épaisseurs de l'ordre de la fraction de micromètre (dépendant de la longueur d'onde du faisceau laser) sont ainsi fondues et la resolidification s'effectue ensuite par épitaxie sur la partie du substrat qui n'a pas été fondue.

Le fait d'utiliser un faisceau laser pulsé permet d'apporter successivement de grandes quantités d'énergie sur le semiconducteur sans pour autant l'endommager définitivement. Il est également possible d'employer un faisceau non pulsé mais d'énergie moindre. On peut utiliser, au lieu d'un rayonnement laser, un rayonnement d'électrons ou d'ions pour atteindre le même but.

On remarque sur la figure 3 le décalage qui existe entre les courbes en direct et en inverse pour une diode de référence et pour une diode ayant subi le traitement selon l'invention. A titre indicatif, la diode traitée a reçu une énergie de 480 mJ/$cm^2$ délivrée par une irradiation présentant un mélange de deux longueurs d'onde : verte (20 %) et infra-rouge (80 %), la durée des impulsions délivrées par un laser Nd-YAG étant de 25 ns. Le point M' donne la valeur de Is pour cette diode.

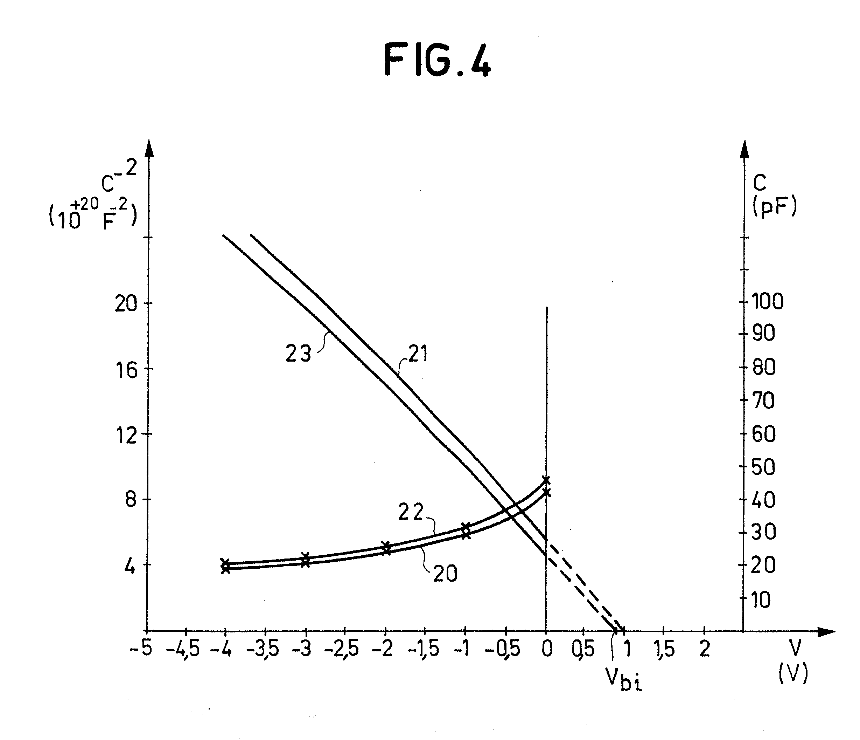

La figure 4 est un diagramme C(V) qui donne aussi l'allure de $C^{-2}$ en fonction de la tension V appliquée en inverse à la diode pour une diode non traitée selon l'invention. En abscisse on a porté la tension V. L'axe des ordonnées de droite représente les valeurs de C mesurées. L'axe des ordonnées de gauche représente les valeurs de $C^{-2}$. Des mesures de C ont été relevées pour différentes valeurs de V. La courbe 20 des valeurs de C a été tracée pour une fréquence de la tension appliquée de 1 MHz et transposée en une courbe 21 représentant $C^{-2}$. De même la courbe 22 représente C en fonction de V et la courbe 23 représente $C^{-2}$, pour une fréquence de 10 kHz. Les intersections des prolongements des courbes 21 et 23 avec l'axe des tensions donnent les valeurs de Vbi pour les fréquences correspondantes. Les valeurs de Vbi relevées sur la figure 4 sont de l'ordre de 0,95 V.

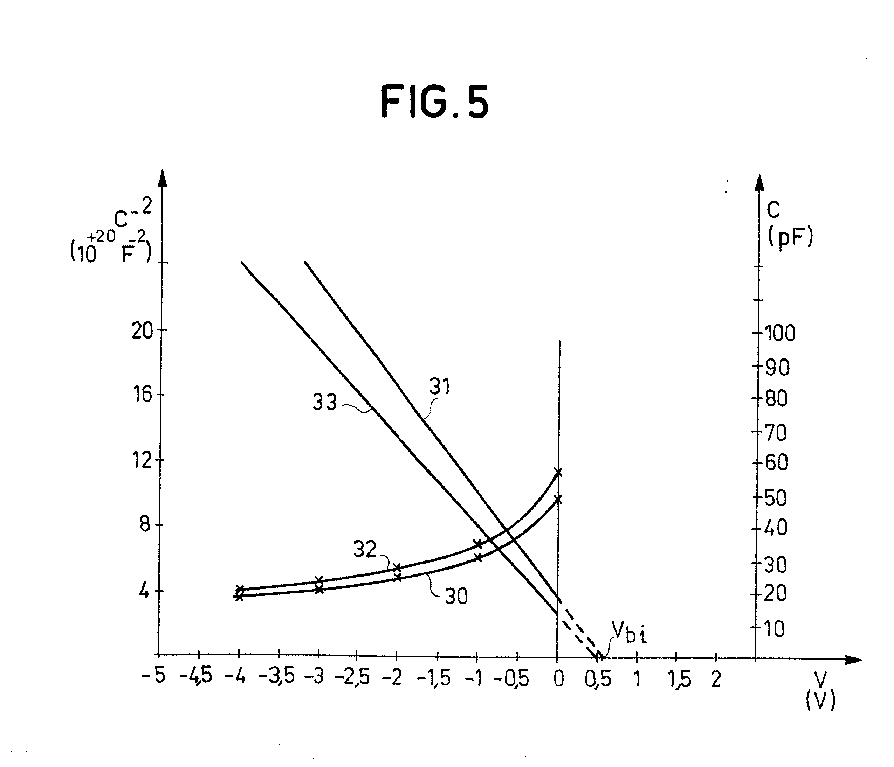

La figure 5 est également un diagramme C(V). Elle se présente comme la figure 4 mais concerne une diode qui a subi le traitement selon l'invention décrit plus haut. Les courbes 30 et 31 représentent respectivement C et $C^{-2}$ en fonction de V, pour une fréquence de 1 MHz. Les courbes 32 et 33 représentent respectivement C et $C^{-2}$ en fonction de V, pour une fréquence de 10 kHz. Dans ce cas, les valeurs de Vbi sont de l'ordre de 0,65 V ce qui représente un abaissement de la hauteur de barrière de l'ordre de 300 mV par rapport au matériau non traité. Le même résultat peut bien sûr être obtenu avec un laser rubis. Les densités d'énergie apportées ne doivent pas créer de dégradation dans le volume du matériau irradié mais doivent être suffisamment élevées pour amorcer la fusion de la surface. Les densités d'énergie optimales vont dépendre de la capacité calorifique et de la conduction thermique du cristal irradié ainsi que de la longueur d'absorption des particules énergétiques considérées. En ce qui concerne l'arséniure de gallium, l'énergie des doses d'irradiation devra rester inférieure à 1,5 joule/$cm^2$. En particulier, pour la longueur d'onde verte (0,53 micromètre) l'énergie déposée doit être inférieure à 350 mJ/$cm^2$. Pour la longueur d'onde rouge (0,69 micromètre), elle doit être inférieure à 600 mJ/$cm^2$. Pour un mélange vert et infra-rouge (0,53 et 1,06 micromètre), l'énergie maximale admissible de la dose d'irradiation varie avec la proportion de vert dans le mélange vert-infra-rouge. La limite inférieure d'énergie admissible est imposée par la présence effective d'une fusion superficielle du cristal et varie avec les longueurs d'absorption.

La barrière de surface naturelle qui existe sur un semiconducteur entraîne souvent pour la réalisation de circuits intégrés à transistors à effet de champ (MESFET sur arséniure de gallium par exemple) une opération technologique supplémentaire rendue nécessaire afin de réduire l'influence de la hauteur de barrière entre et sous les contacts (source-drain).

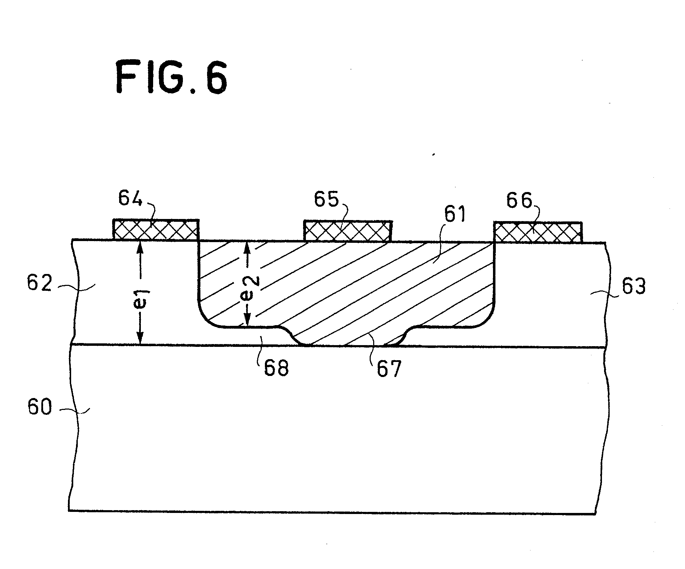

La figure 6 est une vue partielle en coupe d'un tel transistor. On distingue un substrat 60 semi-isolant, une zone 61 sans porteurs libres, deux zones 62 et 63 dopées n d'une concentration d'impuretés Nd = $5.10^{16}$ atomes/$cm^3$. L'épaisseur $e_1$ fait par exemple, dans un cas de réalisation,

1500 Å et l'épaisseur $e_2$ fait 1300 Å. La zone 61 présente donc un étranglement 67 de 200 Å d'épaisseur. Les électrodes 64, 65 et 66 représentent respectivement la source, la grille et le drain. On admet que pour une barrière $\Phi_{bn}$ grille-canal de 0,9 eV, la tension de seuil de cette structure est de + 0,1 V. Le passage d'un courant entre source et drain se fait lorsque la partie 67 devient, sous l'influence de tensions de polarisation, un canal de conduction. Entre source et grille ainsi qu'entre grille et drain existe une barrière de surface d'environ 0,7 eV qui dépeuple presque complètement les zones conductrices 62 et 63 de leurs porteurs de charges. Ceci conduit à une résistance d'accès prohibitive pour des dispositifs rapides.

Ces considérations ont conduit à envisager diverses solutions qui permettent de diminuer cette résistance d'accès. Une première solution consiste à creuser la zone 61 afin de rapprocher le contact de grille du substrat 60. Cette structure est désignée en anglais par le terme "recess". La difficulté majeure de cette solution consiste dans l'ajustement de la profondeur du creux effectué dans la zone 61. Une seconde solution consiste dans le surdopage des régions de la zone 61 comprise entre la source et la grille d'une part et la grille et le drain d'autre part. Ce dopage s'effectue par implantation ionique auto-alignée. La difficulté de cette solution réside dans la nécessité de disposer d'une grille réfractaire stable pendant le recuit d'activation des atomes donneurs implantés (température de recuit : environ 800° C dans le cas de l'arséniure de gallium).

L'invention permet, en contrôlant la hauteur de barrière métal-semiconducteur, de diminuer cette barrière (entre source et grille et entre grille et drain). Il est possible, dans le cas d'un semiconducteur de type n, d'abaisser cette barrière de 300 mV dans l'exemple cité plus haut. La résistance de contact étant directement liée au dopage et à la hauteur de barrière, on peut obtenir de bons contacts ohmiques en combinant des techniques de surdopage et de contrôle de hauteur de barrière. L'irradiation par faisceaux laser de la face supérieure du transistor de la figure 6 permet de diminuer l'épaisseur $e_2$ et donc la résistance d'accès de la structure. En faisant subir à cette structure un traitement dans les conditions exposées plus haut, on peut arriver à réduire $e_2$ jusqu'à 1000 Å et donc augmenter l'épaisseur de la zone d'accès 68 au canal de conduction de 150 %. La prise des contacts ohmiques source et drain est également améliorée. Le rayonnement laser n'affectera que la surface du semiconducteur et non les électrodes. En effet, pour des raisons pratiques de représentation, les élecrodes 64, 65 et 66 ne sont pas représentées à l'échelle. En fait, leur épaisseur est de l'ordre du micron et leur réflectivité étant élevée (cas de l'or ou de l'aluminium), elles ne sont que très peu affectées par le rayonnement laser.

Si le traitement selon l'invention permet d'abaisser la hauteur de barrière d'un contact métal-semiconducteur de type n, il relève par contre cette hauteur de barrière pour un contact métal-semiconducteur de type p. Il est alors possble d'obtenir des diodes Schottky sur semiconducteur de type p avec un métal peu réactif. Le traitement selon l'invention est particulièrement avantageux pour ce type de diode puisque, pour des surfaces non traitées, seuls les métaux alcalins étaient utilisables.

Il entre également dans le cadre de l'invention d'appliquer le procédé d'abaissement du potentiel de surface d'un matériau semiconducteur à tout dispositif utilisant un tel matériau, en combinaison ou non avec un métal. Le procédé permet de passiver au moins partiellement des surfaces semiconductrices.

REVENDICATIONS

1. Procédé de passivation d'au moins une région (4) superficielle d'un matériau semiconducteur sur une épaisseur déterminée, caractérisé en ce qu'il comporte une étape consistant à irradier ladite région à l'aide d'un faisceau énergétique, la quantité d'énergie apportée à ladite région étant suffisante pour dépasser le point de fusion dudit matériau par échauffement et étant inférieure à son point de destruction, de manière à modifier le potentiel de surface de ladite région.

2. Procédé de passivation selon la revendication 1, caractérisé en ce que ledit matériau semiconducteur est de type p, ladite irradiation contribuant à augmenter ledit potentiel de surface.

3. Procédé de passivation selon la revendication 1, caractérisé en ce que ledit matériau semiconducteur est de type n, ladite irradiation contribuant à abaisser ledit potentiel de surface.

4. Procédé de passivation selon l'une quelconque des revendications 1 et 3, caractérisé en ce que ledit faisceau énergétique est un faisceau pulsé.

5. Procédé de passivation selon l'une quelconque des revendications 1 à 4, caractérisé en ce que ledit faisceau énergétique est un faisceau photonique.

6. Procédé de passivation selon l'une quelconque des revendications 1 à 4, caractérisé en ce que ledit faisceau énergétique est un faisceau d'électrons.

7. Procédé de passivation selon l'une quelconque des revendications 1 à 4, caractérisé en ce que ledit faisceau énergétique est un faisceau d'ions.

8. Procédé de passivation selon la revendication 5, caractérisé en ce que ledit faisceau photonique est délivré par un laser.

9. Procédé de passivation selon la revendication 8, caractérisé en ce que ledit faisceau photonique possède un spectre qui comporte au moins deux raies de longueurs d'onde distinctes.

10. Procédé de passivation selon la revendication 9, caractérisé en ce que ledit spectre comporte deux raies de longueurs d'onde, la répartition énergétique de ces longueurs d'onde dans ledit faisceau étant de 20 % pour une première raie de longueur d'onde 0,53 micromètre et de 80 % pour une seconde raie de longueur d'onde 1,06 micromètre.

11. Procédé de passivation selon l'une quelconque des revendications 1 à 9, caractérisé en ce que ledit matériau semiconducteur est formé d'un composé dont les éléments sont situés dans les groupes III et V du tableau périodique des éléments.

12. Procédé de passivation selon la revendication 11, caractérisé en ce que ledit matériau semiconducteur est de l'arséniure de gallium.

13. Procédé de fabrication d'un dispositif à semiconducteur, caractérisé en ce qu'il comprend une étape de passivation selon l'une quelconque des revendications 1 à 12.

14. Procédé de fabrication selon la revendication 13, caractérisé en ce que ledit dispositif comprend au moins un contact entre un métal (3) et ledit matériau semiconducteur (4).

15. Procédé de fabrication selon la revendication 14, caractérisé en ce que ledit métal est de l'or.

16. Procédé de fabrication selon la revendication 14, caractérisé en ce que ledit métal est de l'aluminium.

17. Procédé de fabrication selon l'une des revendications 14 à 16, caractérisé en ce que ledit dispositif électronique est une diode Schottky.

18. Procédé de fabrication selon l'une des revendications 14 à 16, caractérisé en ce que ledit contact est un contact ohmique.

19. Procédé de fabrication selon l'une des revendications 14 à 16, caractérisé en ce que ledit dispositif électronique est un transistor à effet de champ.

20. Procédé de fabrication selon l'une quelconque des revendications 13 à 19, caractérisé en ce que ledit faisceau énergétique irradie des zones dudit matériau semiconducteur qui ont été surdopées.

# FIG.1

# FIG.2

FIG.3

# FIG.4

# FIG.5

0109321

FIG.6

Office européen
des brevets

**RAPPORT DE RECHERCHE EUROPEENNE**

0109321
Numéro de la demande

EP 83 40 2076

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | APPLIED PHYSICS LETTERS, vol. 34, no. 9, mai 1979, pages 558-560, American Institute of Physics, New York, US D.H. AUSTON et al.: "Dual-wavelength laser annealing" * Résumé, page 558 * | 1,4,5, 8-10, 20 | H 01 L 21/268 H 01 L 21/263 H 01 L 21/285 |
| | --- | | |
| A | EXTENDED ABSTRACTS, vol. 82-2, octobre 1982, pages 248-249, abrégé no. 157, Pennington, New Jersey, US D.J. GODFREY et al.: "A study of pulsed laser and multiplescan electron beam annealing of arsenic implanted N-channel MOS transistor source/drain regions" * En entier * | 1,4-6, 8,19, 20 | |
| | --- | | **DOMAINES TECHNIQUES RECHERCHES (Int. Cl. ³)** |
| A | EXTENDED ABSTRACTS, vol. 79-2, 14-19 octobre 1979, Fall meeting, pages 1279-1281, abrégé no. 506, Princeton, US I. GOLECKI et al.: "Transient annealing of GaAs by electron and laser beams" * En entier * | 1,4-6, 8,11, 12 | H 01 L |
| | --- -/- | | |

Le présent rapport de recherche a été établi pour toutes les revendications

| Lieu de la recherche | Date d'achèvement de la recherche | Examinateur |
|---|---|---|
| LA HAYE | 13-02-1984 | VANCRAEYNEST F.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

            & : membre de la même famille, document correspondant

OEB Form 1503 03.82

0109321
Numéro de la demande

**RAPPORT DE RECHERCHE EUROPEENNE**

Office européen
des brevets

EP 83 40 2076

Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | APPLIED PHYSICS LETTERS, vol. 36, no. 1, janvier 1980, pages 56-59, American Institute of Physics, New York, US D.M. ZEHNER et al.: "Preparation of atomically clean silicon surfaces by pulsed laser irradiation" * En entier * | 1,4,5, 8 | |
| A | IEEE ELECTRON DEVICE LETTERS, vol. EDL-2, no. 5, mai 1981, pages 115-117, IEEE, New York, US W.T. ANDERSON JR et al.: "Laser annealed Ta/Ge and Ni/Ge ohmic contacts to GaAs" * En entier * | 1,3,5, 8,11, 14,18, 19 | |
| A | PATENTS ABSTRACTS OF JAPAN, vol. 6, no. 9 (E-90)[887], 20 janvier 1982 & JP - A - 56 131 934 (FUJITSU K.K.) 15-10-1981 | 1,8,11 -13 | DOMAINES TECHNIQUES RECHERCHES (Int. Cl. 3) |
| A | PATENTS ABSTRACTS OF JAPAN, vol. 6, no. 155 (E-125)[1033], 17 août 1982 & JP - A - 57 76 846 (FUJITSU K.K.) 14-05-1982 | 1,8 | |

Le présent rapport de recherche a été établi pour toutes les revendications

| Lieu de la recherche LA HAYE | Date d'achèvement de la recherche 13-02-1984 | Examinateur VANCRAEYNEST F.H. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant